Europäisches Patentamt

(19) European Patent Office

Office européen des brevets

(11) Publication number : **0 128 941**
**B1**

(12) # EUROPEAN PATENT SPECIFICATION

(45) Date of publication of patent specification :
25.03.87

(51) Int. Cl.⁴ : **G 01 R 19/02, G 01 R 17/06**

(21) Application number : 84900314.0

(22) Date of filing : 14.12.83

(86) International application number :
**PCT/SE 83/00450**

(87) International publication number :
**WO/8402581 (05.07.84 Gazette 84/16)**

(54) **METHOD OF MEASURING A DC CURRRENT OR A LOW-FREQUENCY AC CURRENT.**

(30) Priority : 21.12.82 SE 8207304

(43) Date of publication of application :
27.12.84 Bulletin 84/52

(45) Publication of the grant of the patent :
25.03.87 Bulletin 87/13

(84) Designated contracting states :
AT CH DE FR GB LI NL

(56) References cited :
CH-A- 593 493
DE-A- 2 300 802
SE-C- 103 331
Elteknik med aktuell elektronik, p. 20-22, 1978: 12,
Bertil Lundqvist: "Mätning av starkström-gammal
metod häller än"

(73) Proprietor : TELEFONAKTIEBOLAGET L M ERICSSON
S-126 25 Stockholm (SE)

(72) Inventor : HAGELIN, Frank, Helge
Humlestigen 11
S-125 31 Älvsjö (SE)

(74) Representative : Szemere, Fredrik et al
Telefonaktiebolaget L M Ericsson Patent Department
S-126 25 Stockholm (SE)

## Description

### Technical field

The present invention relates to a method of measuring a DC current or a low-frequency AC current with the aid of a transformer having a first and a second winding (2 and 3), where the current is supplied to the first winding 2, and where for compensating the flux in the transformer core 1 caused by the current in the first winding, there is supplied a compensating current to the second winding 3 having a value corresponding to the transformed value of the current in the first winding.

### Background art

In applications such as safety systems for railway signals controlled by computerised switchgear, there is a need of galvanically insulated measurement of the effective value of the lamp currents.

In e. g. the Swiss patent n° 593 493 is described a method of measuring a DC current with the aid of a transformer core. The DC current to be measured is connected to a winding which brings about a magnetic flux in the core. The flux is measured by a hall generator in a slot in the core and its output signal controls a current generator. The current generator brings about a counterdirected flux in the core and is controlled in dependence on the resultant flux measured in the core until zero flux is achieved. At zero flux the output current from the current generator corresponds to the DC current to be measured. This method and similar known methods of measuring a DC current with the aid of a transformer core are both complicated and expensive, however.

### Disclosure of invention

The object of the present invention consists in providing a simple and cheap method of transforming a DC current or a low-frequency AC current with the aid of a transformer.

This object is achieved in accordance with the invention by the method being given the characterizing features disclosed in the claim.

### Description of figure

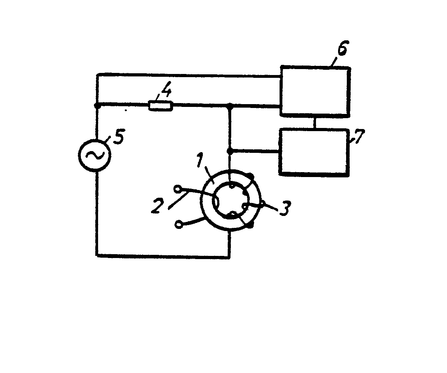

The invention will be described below with reference to the accompanying drawing, the sole figure on which illustrates an embodiment of an apparatus for carrying out the method in accordance with the invention.

### Preferred embodiment

An embodiment of an apparatus for carrying out the method in accordance with the invention is illustrated in the Figure, and is intended for transforming a DC or low-frequency AC current with the aid of a transformer, the core 1 of which is assumed to be a toroidally shaped ferrite core in the illustrated embodiment, through the central hole of which there is inserted the primary winding in the shape of a wire 2, this core carrying a secondary winding 3 having a predetermined number of turns for obtaining a predetermined transformation ratio in the transformer.

The DC or low-frequency AC current which is to be transformed is applied to the transformator primary winding 2 in a manner not more closely illustrated.

A modulating voltage source 5 is connected across the secondary winding 3 of the transformer, in series with a phase-shifting network, which is a resistor 4 in the illustrated embodiment. Via the resistor 4 the source 5 is adapted for applying a modulating voltage across the secondary winding 3 with an amplitude such that the transformator core 1 is saturated. By « low-frequency current » is intended in this context a current having a frequency amounting to at most about 1/10 of that of the modulating voltage source 5. This in turn amounts to between 5 and 10 kHz for a core diameter of about 8 mm.

The current through the primary winding 2 causes a magnetic flux in the transformer core 1, and according to the invention this flux is compensated by a current being supplied to the secondary winding 3 until the flux in the core 1 becomes equal to zero, the compensating current through the secondary winding 3 then constituting a copy of the current in the primary winding 2 transformed over at the transforming ratio of the transformer.

In accordance with the invention, the compensating current is achieved in the following manner :

A phase comparator 6 has both its inputs connected to the connection point for the modulating voltage source 5 and the resistor 4, and also to the connection point for the resistor 4 and the transformer secondary winding 3, the comparator being such as to measure at two consecutive zero passages the separation in phase between the voltage of the modulating voltage source 5 and the voltage across the transformer secondary winding 3. The comparator 6 is further adapted to generate a control signal in response to the difference between both these measured separations in phase. This control signal, which is thus proportional to the difference between the separation phase in two consecutive zero passages, is applied to a controlled compensating current generator (7), which has its output connected to the connection point for the transformer secondary winding 3 and the resistor 4.

The compensating generator 7 is adapted for feeding a current, in response to the mentioned control signal, for compensating the flux in the core 1 caused by the current in the primary winding 2, until the difference between two consecutive, measured separations in phase is zero. When such is the case, the current from the compensating current generator 7 constitutes a copy, transformed over with the transforming ratio, of the current in the primary winding 2. This current may then be measured in a manner known per se for obtaining measure of the current in the primary winding 2.

A DC or a low-frequency AC current may thus be transformed in a simple manner, with the aid of the apparatus for carrying out the method in accordance with the invention.

## Claim

Method of measuring a DC current or a low-frequency AC current with the aid of a transformer having a first and a second winding (2 and 3), where the current is supplied to the first winding (2), and where for compensating the flux in the transformer core (1) caused by the current in the first winding, there is supplied a compensating current to the second winding (3) having a value corresponding to the transformed value of the current in the first winding, characterized in that a modulating voltage is applied to the second winding (3) *via* phaseshifting network (4), the separation in phase between the modulating voltage and the voltage across the second winding (3) of the transformer is measured at two consecutive zero passages, the deviation between both these separations in phase is measured, a signal corresponding to the deviation is generated, and a compensating current generator (7) is controlled with the aid of this signal, the current from the generator being fed to the second winding (3) of the transformer, and in that the deviation between the separations in phase is once again measured, and the process is repeated with continuous addition to the previous deviation values until the deviation becomes zero, the current value from the compensating current generator (7) then giving the measured current.

## Patentanspruch

Verfahren zur Messung eines Gleichstromes oder eines niederfrequenten Wechselstromes mit Hilfe eines Wandlers, der eine erste und zweite Wicklung (2 und 3) aufweist, wobei der Strom der ersten Wicklung (2) zugeführt wird und wobei zur Kompensierung des Flusses im Wandlerkern (1), der durch den Strom in der ersten Wicklung verursacht wird, ein Kompensierungsstrom der zweiten Wicklung (3) zugeführt wird mit einem Wert, der dem gewandelten oder transformierten Wert des Stromes in der ersten Wicklung entspricht, dadurch gekennzeichnet, daß eine Modulationsspannung an die zweite Wicklung (3) über ein Phasenschiebernetzwerk (4) angelegt wird, daß die Phasentrennung zwischen der modulierenden Spannung und der Spannung quer zur zweiten Wicklung (3) des Wandlers in zwei aufeinanderfolgenden Null-Durchgängen gemessen wird, daß die Abweichung zwischen diesen Phasentrennungen gemessen wird, daß ein Signal entsprechend der Abweichung erzeugt wird und ein Kompensierungsstromgenerator (7) mit Hilfe dieses Signales gesteuert wird, wobei der Strom aus dem Generator der zweiten Wicklung (3) des Wandlers zugeführt wird, und daß die Abweichung zwischen den Phasentrennungen nochmals gemessen wird und der Prozeß wiederholt wird mit fortlaufender Addition zu den vorhergehenden Abweichungswerten, bis die Abweichung Null wird, wobei der Stromwert aus dem Kompensierungsstromgenerator (7) dann den gemessenen Strom liefert.

## Revendication

Procédé de mesure d'un courant continu ou d'un courant alternatif à basse fréquence à l'aide d'un transformateur comportant des premier et second enroulements (2 et 3), dans lequel le courant est fourni au premier enroulement (2), et dans lequel, pour compenser le flux engendré dans le noyau (1) du transformateur par le courant passant dans le premier enroulement, il est fourni au second enroulement (3) un courant de compensation ayant une valeur correspondant à la valeur transformée du courant passant dans le premier enroulement, caractérisé en ce que une tension de modulation est appliquée au second enroulement (3) par l'intermédiaire d'un réseau (4) de décalage de phase, la séparation de phase entre la tension de modulation et la tension aux bornes du second enroulement (3) du transformateur est mesurée à deux passages consécutifs par zéro, l'écart entre ces deux séparations de phase est mesuré, un signal correspondant à l'écart est généré, et un générateur (7) de courant de compensation est commandé à l'aide de ce signal, le courant du générateur étant appliqué au second enroulement (3) du transformateur, et en ce que l'écart entre les séparations de phase est mesuré une fois de plus, et le procédé est répété avec une addition continue aux valeurs d'écart précédentes jusqu'à ce que l'écart devienne nul, la valeur du courant provenant du générateur (7) de courant de compensation donnant alors le courant mesuré.